# EUROPEAN PATENT SPECIFICATION

(11) **EP 2 535 786 B1**
(45) Date of publication and mention of the grant of the patent: **24.02.2016**
(21) Application number: 11852273.9
(22) Date of filing: 28.12.2011
(51) Int. Cl.: G06F 1/20, H05K 7/14, G06F 1/18

(54) **SERVER, SERVER ASSEMBLIES AND FAN SPEED CONTROL METHOD**
SERVER, SERVERANORDNUNGEN UND VERFAHREN ZUR STEUERUNG EINER LÜFTERGESCHWINDIGKEIT
SERVEUR, ENSEMBLE DE SERVEURS ET PROCÉDÉ DE RÉGULATION DE LA VITESSE D'UN VENTILATEUR

(30) Priority: 28.12.2010 CN 201010609683
(43) Date of publication of application: 19.12.2012
(73) Proprietor: Huawei Technologies Co., Ltd., Longgang District Shenzhen, Guangdong 518129 (CN)
(72) Inventor: ZHOU, Jianjun, Shenzhen Guangdong 518129 (CN); WU, Zhan, Shenzhen Guangdong 518129 (CN); XIAO, Lin, Shenzhen Guangdong 518129 (CN)
(74) Representative: Kreuz, Georg Maria
(86) International application number: PCT/CN2011/084839
(87) International publication number: WO 2012/089128

(56) References cited:
- CN-A- 1 700 143
- CN-A- 1 912 797
- CN-A- 101 196 761
- CN-A- 102 129 274
- US-A1- 2008 232 974
- US-A1- 2008 239 649
- US-A1- 2008 310 097
- US-A1- 2009 016 010
- US-A1- 2009 190 297
- US-B1- 7 348 743
- Server System Infrastructure Group: "Enterprise Electronics Bay Specification for 2008 dual-Socket Servers and Workstation", , 31 December 2012 (2012-12-31), pages 1-38, XP002690700, Retrieved from the Internet: URL:https://ssiforum.org/index.php?option= com_docman&task=doc_download&gid=243&Itemi d=13 [retrieved on 2013-01-22]

## Description

### FIELD OF THE INVENTION

The present invention relates to the field of communication technologies, and in particular, to a server, a server component and a method for controlling a fan speed.

### BACKGROUND OF THE INVENTION

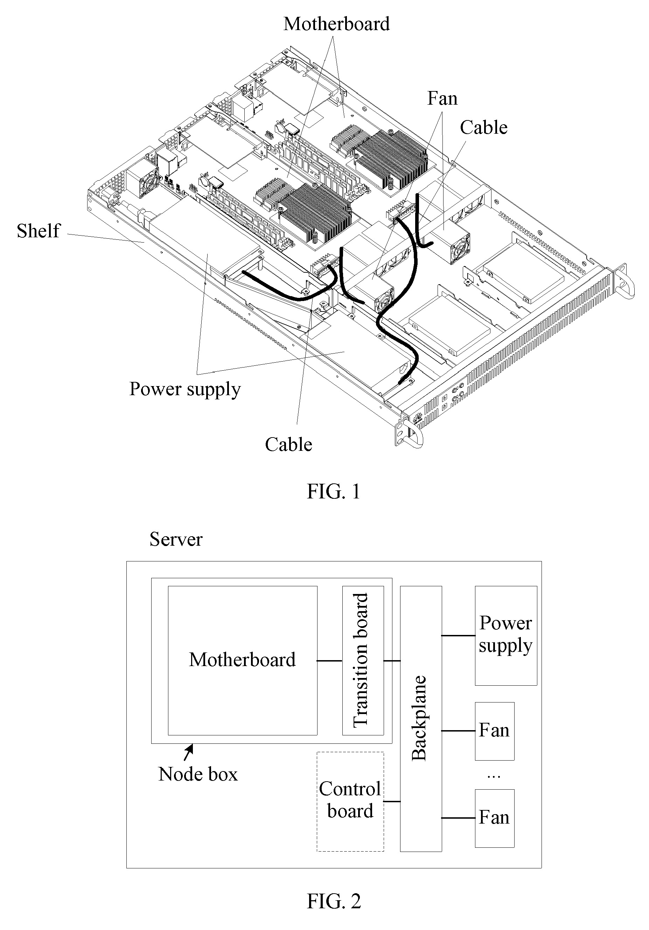

With the rapid development of cloud computing and data centers, a demand for servers also increases rapidly. Referring to FIG. 1, which is a schematic diagram of existing server architecture, a server includes parts such as a shelf, a motherboard, a power supply, and a fan. The motherboard is a main unit for the server to perform data processing; the power supply is used to supply power to the motherboard, and the fan is used to dissipate heat for the motherboard. Each fan interface in a motherboard of each server is directly connected to a corresponding fan in the server through a cable, and each power interface in the motherboard of each server is also directly connected to a corresponding power supply in the server through a cable.

The prior art has the following disadvantages:

When the motherboard needs to be replaced, because a difference may exist between the number of interfaces in a new motherboard and the number of interfaces in an old motherboard, for example, the new motherboard has two more fan interfaces, in this case, the numbers of fans in the server cannot satisfy a requirement of the new motherboard, so that the motherboard cannot be replaced, thereby causing poor flexibility of replacing the motherboard for the server.

US 2008/0232974 A1 relates to cooling an operation unit and to suppressing power consumption and noise according to the configuration and the operation state in a computer system of an enclosure. A plurality of system cooling fans for cooling the operation unit of the computer system installed in the enclosure and an enclosure management module for controlling the rotation of each system cooling fan are arranged, where the enclosure management module stores in advance the supply cooling amount which is to be supplied to the operation unit by each system cooling fan, acquires information related to a temperature of the operation unit and calculates a necessary cooling amount which is to be required in the operation unit based on the information, and determines the rotation number of each system cooling fan based on the supply cooling amount and the necessary cooling amount.

### SUMMARY OF THE INVENTION

The present invention provides a server and a method according to the appended claims for controlling a fan speed, which are used to improve flexibility of replacing a motherboard for the server.

The foregoing technical solutions have the following advantages:

By adding the transition board, the power interfaces and the fan interfaces on the transition board are connected to the a standardized power interface and a standardized fan interface on the motherboard respectively, and then are connected to the power supply and the fan through the backplane; while the number of the power interfaces on the transition board and the number of the fan interfaces on the transition board are not smaller than the maximum number of the power interfaces in the commonly-used server motherboard and the maximum number of the fan interfaces in the commonly-used server motherboard respectively; in this way, when the motherboard needs to be replaced, the numbers of interfaces on the transition board can satisfy an application of a new motherboard as long as the new motherboard is a commonly-used motherboard, and then replacement of the motherboard may be completed and the flexibility of replacing the motherboard for the server is increased.

### BRIEF DESCRIPTION OF THE DRAWINGS

To illustrate technical solutions of the present invention more clearly, accompanying drawings describing embodiments or the prior art are briefly introduced in the following. Apparently, the accompanying drawings in the following description show merely some embodiments of the present invention.
FIG. 1 is a schematic diagram of a server in the prior art;
FIG. 2 is a schematic structural diagram of a server according to an example;
FIG. 3 is another schematic structural diagram of the server according to an example;
FIG. 3A is a schematic structural diagram of the server after a shelf is removed according to an example;
FIG. 4 is a schematic diagram of power interfaces of a motherboard according to an embodiment of the present invention;
FIG. 5 is a schematic diagram of fan interfaces of the motherboard according to an embodiment of the present invention;
FIG. 6 is a schematic structural diagram of a transition board according to an embodiment of the present invention; and
FIG. 7 is a schematic diagram of a method for controlling a fan speed according to an embodiment of the present invention.

### DETAILED DESCRIPTION OF THE EMBODIMENTS

To make the objective, technical solutions, and advantages of the present invention clearer, the following further describes the present invention in detail with reference to specific embodiments and relevant accompanying drawings.

### Example

Referring to FIG. 2, the example provides a server, including:
a power supply, a fan, a backplane, a motherboard and a transition board;
the transition board is disposed with power interfaces and fan interfaces, and the power interfaces and the fan interfaces on the transition board are connected to a standardized power interface and a standardized fan interface on the motherboard respectively; the number of the power interfaces on the transition board and the number of the fan interfaces on the transition board are not smaller than the maximum number of power interfaces in a commonly-used server motherboard and the maximum number of fan interfaces in the commonly-used server motherboard respectively;
the power interfaces and the fan interfaces on the transition board are connected to the power supply and the fan through the backplane respectively, so that the power interfaces and the fan interfaces on the motherboard are connected to the power supply and the fan through the power interfaces and the fan interfaces on the transition board respectively.

In the example a motherboard adopting a standardized power interface and a standardized fan interface may be an SSI (Server System Infrastructure, server system infrastructure) standard motherboard, or an EEB (Entry-Level Electronics Bay, entry-level electronics bay) standard motherboard, or a CEB (Compact Electronics Bay, compact electronics bay) standard motherboard, or a TEB (Thin Electronics Bay, thin electronics bay) standard motherboard or other standard motherboards; other known or unknown motherboards adopting a standardized interface are not limited here. It should be noted that the "interfaces" here refer to a group of defined signal sets, and in practical use, each physical signal line in each "interface" is connected through various connectors.

The foregoing "the maximum number of power interfaces in a commonly-used server motherboard and the maximum number of fan interfaces in the commonly-used server motherboard" are numbers that can be easily understood and implemented by those skilled in the art, but do not represent numerical values obtained through strict statistics. For example, for an existing commonly-used motherboard, 1 - 6 fan interfaces of a same type and 1 - 3 power interfaces of different types are adopted generally; therefore, the transition board may satisfy an application demand as long as more than 6 fan interfaces and more than 3 power interfaces are disposed on the transition board. If a commonly-used motherboard in a specific application field of a server product generally only needs 3 fan interfaces and 1 power interface at most, the transition board may satisfy an application demand as long as more than 3 fan interfaces and more than 1 power interface are disposed on the transition board. If in future there is a new motherboard which needs more interfaces, and this becomes "commonly-used" (when needed), the number of interfaces on the transition board may also be adaptively adjusted to adapt to the maximum number of interfaces in such a "commonly-used" case. Actually, in the foregoing two taken examples, the number of fan interfaces is not necessarily more than 6 or more than 3, but disposing 5 or 2 is also an equivalent implementation manner (which has relatively poor flexibility, that is, replacement by a motherboard with 6 fan interfaces or 3 power interfaces cannot be implemented), or those skilled in the art may adopt other equivalent implementation manners according to practical applications; the number of interfaces is not limited strictly here.

It should be noted that, in the example, the power interfaces and the fan interfaces on the motherboard are connected to the power supply and the fan through the transition board, which merely indicates that part of signal pins are connected, but does not indicate that each signal pin on the motherboard is connected to each signal pin of the power supply and the fan; those skilled in the art may set that part of signals are directly connected according to practical situations, and that the other part is connected through some control units, or that some signals are not connected; these technologies are all technologies well known to those skilled in the art, and are not described in detail here.

In the example, the motherboard and the transition board are located in a same node box; and the node box is in pluggable connection with the backplane through the transition board. A pluggable connection manner here refers to physical connection, in which generally connection is performed through some connectors, and in this case, the connectors also transmit electrical signals generally, that is, the connectors can also perform signal interaction with the backplane through inside signal lines while performing the physical connection; certainly, a solution of separating an electrical signal from the physical connection is also not limited in the embodiment of the present invention, that is, connection of the electrical signals and physical pluggable connection are separately implemented by adopting different connectors.

In the example, interfaces (including the power interfaces and the fan interfaces) on the transition board may be connected to interfaces (including the power interfaces and the fan interfaces) on the motherboard through pluggable cables, thereby reducing a design requirement of each interface position in the motherboard; an interface position in the motherboard may be disposed at will as long as the cables have proper lengths (which is very easy to satisfy), thereby increasing flexibility of motherboard design; furthermore, by connecting through the pluggable cables, disconnection may also be performed conveniently, and maintenance difficulty is reduced. Certainly, other manners for connecting the interfaces on the transition board to the interfaces on the motherboard are also not limited in the embodiment of the present invention, for example, performing connection by adopting plug pins and sockets at fixed positions.

The server in the example may further include control units, configured to control the fan and/or the power supply according to information on the motherboard; the control units may be disposed in the transition board and the backplane; a control unit in the transition board acquires information of the motherboard, while a control unit in the backplane is configured to adjust the fan and the power supply according to the information of the motherboard; or one more control board may be further added, is connected to the transition board, and is connected to the power supply and the fan through the backplane; the control units may be disposed in the transition board and the control board; a first control unit in the transition board is configured to acquire information of the motherboard, while a second control unit in the control board is connected to the fan through the backplane, and is configured to control the fan according to the information of the motherboard.

It may be seen that, in the example, by adding the transition board, the power interfaces and the fan interfaces on the transition board are connected to a standardized power interface and a standardized fan interface on the motherboard respectively, and then are connected to the power supply and fan through the backplane; while the number of the power interfaces on the transition board and the number of the fan interfaces on the transition board are not smaller than the maximum number of the power interfaces in the commonly-used server motherboard and the maximum number of the fan interfaces in the commonly-used server motherboard respectively; in this way, when the motherboard needs to be replaced, the numbers of interfaces on the transition board can satisfy an application of a new motherboard as long as the new motherboard is a commonly-used motherboard, and then replacement of the motherboard may be completed and the flexibility of replacing the motherboard for the server is increased.

Furthermore, the motherboard and the transition board are located in the same node box, and the node box may be plugged in or unplugged from the backplane through the transition board; in this way, when the motherboard needs to be replaced, the whole node box may be plugged in or unplugged from the backplane, instead of powering off first, opening a cover, and then unplugging cables connected to the motherboard in the prior art, thereby greatly increasing convenience of maintenance.

### Embodiment 1

The embodiment of the present invention is based on the example , and specifically described by taking a rack server as an example; it should be noted that architecture of a server in the embodiment of the present invention may also be applied to a blade server or other similar servers.

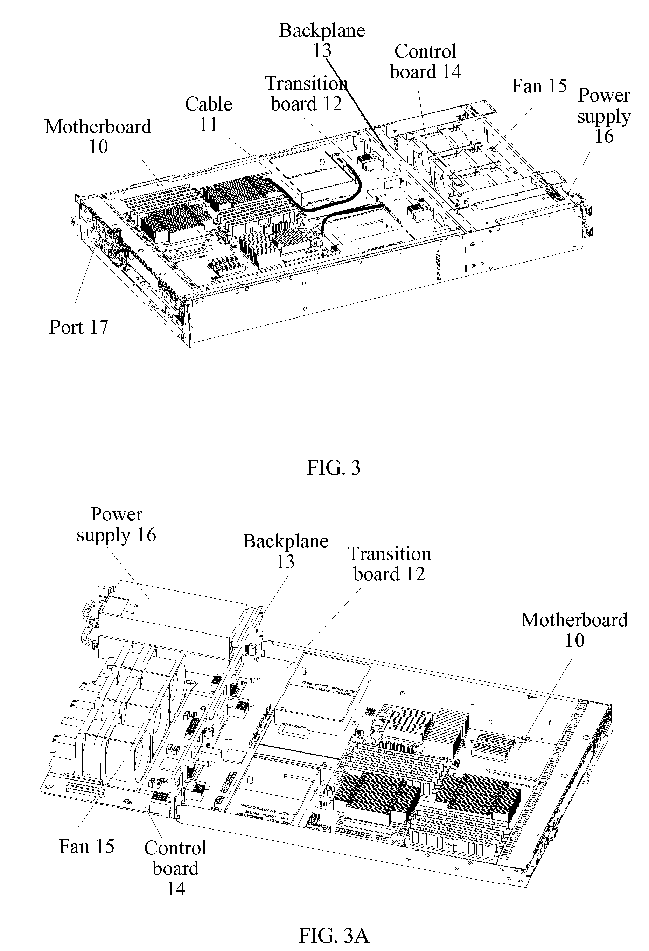

Referring to FIG. 3, which is a schematic structural diagram of the rack server according to the example, in the server, a motherboard 10 (what is shown in the figure is a standard motherboard), a transition board 12, a backplane 13, a fan 15 and a power supply 16 are included. Refer to FIG. 3A, which is a schematic structural diagram of the server after a shelf is removed, so that an internal structure of the server is shown more clearly.

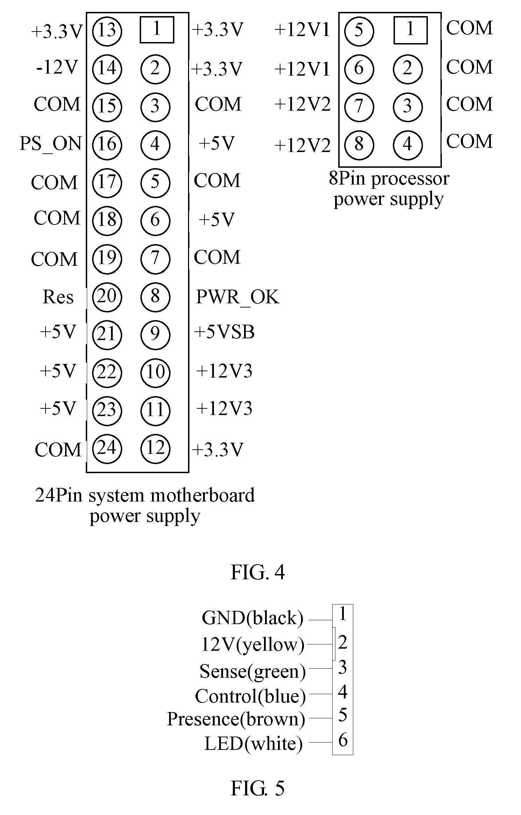

The motherboard here generally adopts a standard motherboard, so the motherboard also has standard power interfaces and fan interfaces. Referring to FIG. 4, power interfaces adopted by an SSI standard motherboard include interfaces of a 24Pin system motherboard power supply and an 8Pin processor power supply. Referring to FIG. 5, fan interfaces adopted by the SSI standard motherboard are shown, and a specific definition of each signal in each interface is specifically described in an SSI standard, and is not described in detail here. It should be noted that the motherboard may also be nonstandard in some features, for example, a motherboard with a nonstandard length and width may be adopted, but both the fan interfaces and the power interfaces of the motherboard should be standard. These standard interfaces are connected to other interfaces (such as power interfaces and fan interfaces in the transition board) through connectors specifically.

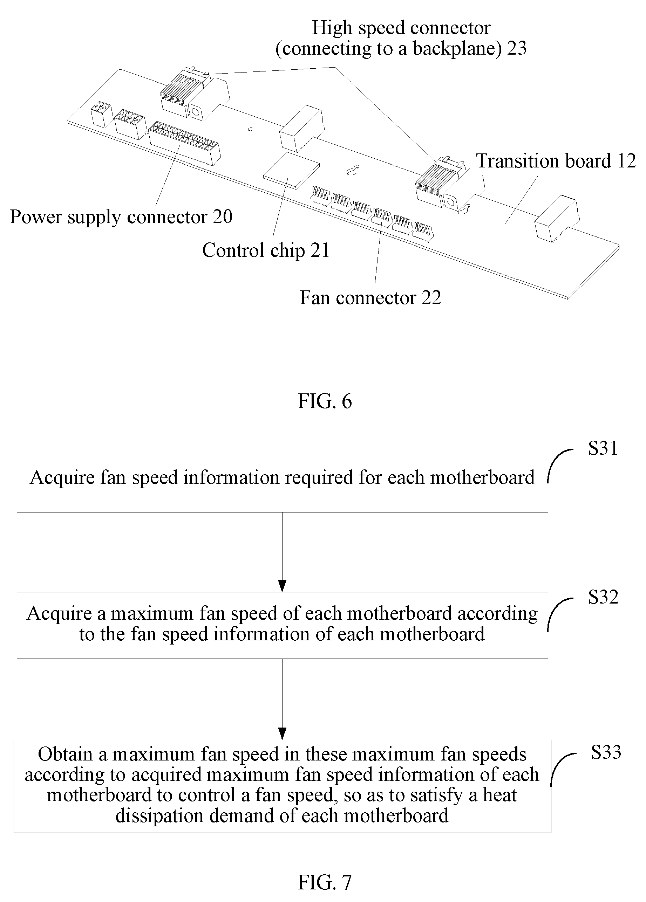

Referring to FIG. 6, which is a schematic diagram of the transition board in the embodiment of the present invention, the transition board is also disposed with power interfaces and fan interfaces corresponding to the motherboard; these interfaces are connected to other interfaces (connectors) in forms of power supply connectors 20 and fan connectors 22 respectively; specific types of the power supply connectors and the fan connectors are not limited here; those skilled in the art may select proper connectors to perform connection in accordance with practical application scenarios.

In the embodiment of the present invention, in order to connect and disconnect the transition board and the motherboard conveniently, pluggable cables are selected for connection; at the same time, it is very easy to adjust a length of a cable, so that a design requirement of an interface position in the motherboard is reduced, that is, positions of interfaces in the motherboard may be disposed at anywhere the cable can be connected as long as the cables are long enough, thereby increasing flexibility of motherboard design.

Referring to FIG. 6, a high speed connector 23 is further disposed in the transition board, and is configured to perform pluggable connection with the backplane; a specific type of the connector shown in FIG. 6 is an Airmax connector; certainly, using other connectors to perform the pluggable connection is also not limited in the embodiment of the present invention. Besides performing physical pluggable connection, the high speed connector on the backplane is further configured to perform electrical signal connection on signal lines, that is, some signal pins are also disposed in the connector, and are configured to connect the backplane to signals on the transition board.

Furthermore, a control unit may be further disposed in the transition board, for example, a control chip 21 in FIG. 6 is adopted to implement a control function, a specific type of the control chip is not limited, and the control chip may be a CPU, a single-chip microcomputer, a DSP, an FPGA or other control chips with similar functions, and is configured to acquire some information of the motherboard.

In the embodiment of the present invention, the transition board and the motherboard are fixed in a same node box, and the transition board is in pluggable connection with the backplane. Specifically, a pluggable connector matching the high speed connector of the transition board may be disposed in the backplane to perform the pluggable connection. In this connection manner, if the motherboard needs to be replaced or maintained, the whole node box may be pulled out of the shelf directly instead of powering off the server first, thereby increasing flexibility of maintenance.

In the embodiment of the present invention, besides being configured to perform pluggable physical connection, the backplane is further configured to connect to electrical signals, that is, to connect signal lines in the power supply and the fan to the power interfaces and the fan interfaces in the motherboard through the backplane, specifically, through the high speed connector and wirings on the backplane. Furthermore, the backplane may be further disposed with some level conversion modules to convert power into various power supplies which are needed by the motherboard and connect to the power interfaces of the motherboard. Specific design of the backplane is a technology known to those skilled in the art, and is not described in detail here.

Referring to FIG. 3, the example further includes a control board 14, where the control board is disposed with control units; the control units may be connected to the motherboard through the transition board, may also be connected to the power supply and the fan through the backplane on the other hand, and may be configured to control the power supply and the fan according to some information (which may be acquired by a control unit on the motherboard) on the motherboard, or to notify the motherboard after information of the power supply and the fan is detected, or to perform some other control defined by other users. In fact, the control board is an optional unit; when there are not many signal lines which are connected, this part of control functions may also be implemented by disposing a control unit on the backplane. A reason that in the embodiment of the present invention, the control board is used instead of disposing the control unit on the backplane is that backplane wirings may be simplified and processing complexity may be reduced when there are multiple motherboards. For example, assuming that at present there are 4 motherboards, each motherboard corresponds to one transition board, and there are 5 control signal lines on each motherboard, 4 transition boards have 20 signal lines in total. These signal lines are to be connected to the backplane. However, if it is processed by the control board, only one signal line is connected to the backplane by the control board for each motherboard; in this case, only 4 signal lines are added to the backplane. For the control board, because the backplane needs to connect to the power supply and the fan or some other devices on it, resources on the backplane become a little scarce. In this case, control processing is implemented through the transition board, so that wirings of the backplane may be simplified, and saved resources may be used by other modules on the backplane.

In the embodiment of the present invention, in the server, there is only a full-width standard motherboard; while in other embodiments, two half-width standard motherboards may also be adopted; the two standard motherboards may be fixed in a same node box together with a common transition board, and may also be fixed in one node box together with one transition board separately. The node box is in pluggable connection with the backplane through the transition board, so that the motherboard, the transition board or other units in the node box are maintained conveniently. For convenience of description, one node box (each node box includes one or multiple motherboards) is also referred to as one node of the server here. In practical uses, multiple server nodes may be disposed according to servers of different shelf heights, for example, 4 half-width nodes (each node is 1U in height) or 2 full-width nodes may be placed on a server which is 2U in height.

### Embodiment 2

Because server architecture in the embodiment of the present invention is different from server architecture in the prior art, where in the embodiment of the present invention, a power supply and a fan are both located at one side of a backplane, and are configured to supply power and dissipate heat for all motherboards, instead of supplying power or dissipating heat for a certain specific motherboard connected to them in the prior art, and because heat dissipation demands of the motherboards may be different, a method is needed to control a server, so that final demands of all the motherboards can be satisfied. Based on the foregoing demands, the embodiment of the present invention provides a method for controlling a fan speed based on the foregoing server, where the method includes the following steps:
S31: Acquire fan speed information required for each motherboard;
Speed information required for a fan may be obtained by a motherboard according to its own temperature. The higher the temperature, the higher a required fan speed. Some motherboards also detect temperatures of multiple sections to obtain different required fan speed information.
S32: Acquire a maximum fan speed of each motherboard according to the fan speed information of each motherboard.

As described in step S31, when there are multiple fan speeds, a maximum one is acquired. Certainly, if there is only one, the one may be regarded as a maximum fan speed. This step may be completed by a control unit in a transition board through receiving information on the motherboard.

S33: Obtain a maximum fan speed in these maximum fan speeds according to acquired maximum fan speed information of each motherboard to control the fan speed, so as to satisfy a heat dissipation demand of each motherboard.

This step may be completed by a control board. After receiving the maximum fan speed of each motherboard through the transition board, the control board further obtains a maximum speed in these speeds, and then controls the fan speed according to this speed.

Through the foregoing speed control, one maximum speed required for all the motherboards is obtained. Fan speeds required for other motherboards can also be satisfied (which are all lower than this maximum speed) as long as the fan reaches this speed eventually. In this way, fan speed demands of all the motherboards may be satisfied, that is, the heat dissipation demand of each motherboard is satisfied.

In fact, satisfying the heat dissipation demand of each motherboard is only one of implementation manners; those skilled in the art may also satisfy the heat dissipation demand of each motherboard in combination with other methods for controlling the fan in practical applications. For example, heat dissipation capacities of some fans are adjusted by combining a speed with a duty ratio. That is, in order to reduce power consumption, a fan does not rotate at a full speed all the time, but rotates at a lower speed or stops rotating in a case of a low heat dissipation demand. In this case, after a heat dissipation demand of each fan is obtained, a required fan speed may be satisfied by increasing a duty ratio of a full rotation speed.

If a fan is based on other control policies, the fan (speed, duty ratio, angle, and so on) may also be controlled according to these control policies, so as to satisfy the heat dissipation demand of each motherboard. These can be easily implemented by those skilled in the art through software and hardware in accordance with specific application scenarios, and a specific implementation process is not described in detail here.

When power control is performed, a power supply supplies power to each motherboard through a backplane in a centralized manner. Whether a motherboard is powered on (through a PS-ON signal) is first judged through a control unit in the control board, and then the power is transferred to a standard motherboard through the backplane and the transition board.

It should be noted that, in the method in the embodiment of the present invention, control may also be performed by selecting a proper control unit according to a specific hardware configuration condition of the server. For example, when the control board is not disposed in the server, a control function may be completed by using the control unit in the transition board, or may also be completed by disposing a corresponding control unit in the backplane. During specific implementation, principles are all similar to those in steps S31 to S33. Those skilled in the art may implement various equivalent implementation solutions according to specific constitution of the server.

Persons of ordinary skill in the art may understand that all or part of the processes of the methods in the foregoing embodiments may be implemented by a computer program instructing relevant hardware. The program may be stored in a computer readable storage medium. When the program is executed, the processes of the methods in the foregoing embodiments are performed. The storage medium may be a magnetic disk, an optical disk, a read-only memory (Read-Only Memory, ROM), or a random access memory (Random Access Memory, RAM), and so on.

The foregoing exemplary embodiments further describe the objective, technical solutions, and advantages of the present invention in detail. It should be understood that the foregoing merely describes embodiments of the present invention, and is not intended to limit the present invention.

## Claims

1. A server, comprising:
a power supply (16), a fan (15), a backplane (13), at least two node boxes, each node box comprising a motherboard (10) and a transition board (12), the node box being in pluggable connection with the backplane (13) through the transition board (12); wherein
each transition board (12) is disposed with power interfaces and fan interfaces, and the power interfaces and the fan interfaces on each transition board (12) are connected to a standardized power interface and a standardized fan interface on each motherboard (10) respectively; the number of the power interfaces on each transition board and the number of the fan interfaces on each transition board are not smaller than the maximum number of power interfaces in a commonly-used server motherboard and the maximum number of fan interfaces in the commonly-used server motherboard respectively;
the power interfaces and the fan interfaces on each transition board (12) are connected to the power supply (16) and the fan (15) through the backplane (13) respectively, so that the power interfaces and the fan interfaces on each motherboard are connected to the power supply and the fan through the power interfaces and the fan interfaces on each transition board respectively;
a first control unit is further disposed in each transition board (12) and configured to acquire fan speed information of the motherboard (10), the motherboard (10) being configured to obtain the fan speed information according to its own temperature, wherein the higher the temperature, the higher the fan speed, wherein the first control unit is further configured to acquire a maximum fan speed of the motherboard according to the fan speed information of the motherboard (10); and
the server further comprises a control board (14), wherein the control board is disposed with a second control unit;
wherein the second control unit is connected to the fan through the backplane, and configured to obtain the maximum fan speed of these maximum fan speeds according to the acquired maximum fan speed information of each motherboard (10), to control the fan speed, so as to satisfy a heat dissipation demand of each motherboard (10).

2. The server according to claim 1, wherein
the power interfaces and the fan interfaces on each transition board (12) are connected to the standardized power interface and the standardized fan interface on each motherboard (10) through cables respectively.

3. The server according to claim 1, wherein
each motherboard (10) is a server system infrastructure SSI standard motherboard, or an entry-level electronics bay EEB standard motherboard, or a compact electronics bay CEB standard motherboard, or a thin electronics bay TEB standard motherboard.

4. A method for controlling a fan speed in a server, wherein the method is applied to the server according to any one of claims 1 to 3, and the method comprises the following steps,
in each node box, acquiring (S31), by the first control unit in the transition board (12), fan speed information required for the motherboard (10); wherein, the fan speed information required for the motherboard (10) is obtained by the motherboard (10) according to its own temperature; wherein the higher the temperature, the higher a required fan speed;
in each node box, acquiring (S32), by the first control unit in the transition board (12), a maximum fan speed of the motherboard (10) according to the fan speed information of the motherboard (10); and
obtaining (S33), by the second control unit in the control board (14) of the server, the maximum fan speed of these maximum fan speeds according to the acquired maximum fan speed information of each motherboard (10), to control the fan speed, so as to satisfy a heat dissipation demand of each motherboard (10).

## Patentansprüche

1. Server, der Folgendes aufweist:
eine Stromversorgung (16), einen Lüfter (15), eine Rückwandplatine (13), mindestens zwei Knotenkästen, wobei jeder Knotenkasten eine Hauptplatine (10) und eine Übergangsplatine (12) aufweist, wobei sich der Knotenkasten durch die Übergangsplatine (12) in einer steckbaren Verbindung mit der Rückwandplatine (13) befindet; wobei jede Übergangsplatine (12) mit Stromschnittstellen und Lüfterschnittstellen versehen ist, und die Stromschnittstellen und die Lüfterschnittstellen an jeder Übergangsplatine (12) mit einer genormten Stromschnittstelle bzw. einer genormten Lüfterschnittstelle auf jeder Hauptplatine (10) verbunden sind; die Anzahl der Stromschnittstellen auf jeder Übergangsplatine und die Anzahl der Lüfterschnittstellen auf jeder Übergangsplatine nicht kleiner als die maximale Anzahl der Stromschnittstellen in einer allgemein üblichen Serverhauptplatine bzw. die maximale Anzahl der Lüfterschnittstellen in der allgemein üblichen Serverhauptplatine ist;
die Stromschnittstellen und die Lüfterschnittstellen auf jeder Übergangsplatine (12) durch die Rückwandplatine (13) mit der Stromversorgung (16) bzw. dem Lüfter (15) verbunden sind, so dass die Stromschnittstellen und die Lüfterschnittstellen auf jeder Hauptplatine durch die Stromschnittstellen bzw. die Lüfterschnittstellen jeder Übergangsplatine mit der Stromversorgung und dem Lüfter verbunden sind;
eine erste Steuereinheit ferner in jeder Übergangsplatine (12) angeordnet und konfiguriert ist, Lüfterdrehzahlinformationen der Hauptplatine (10) zu erfassen, wobei die Hauptplatine (10) dazu konfiguriert ist, die Lüfterdrehzahlinformationen entsprechend ihrer eigenen Temperatur zu erhalten; wobei die Lüfterdrehzahl umso höher ist, je höher die Temperatur ist, wobei die erste Steuereinheit ferner dazu konfiguriert ist, eine maximale Lüfterdrehzahl der Hauptplatine entsprechend den Lüfterdrehzahlinformationen der Hauptplatine (10) zu erfassen; und
der Server ferner eine Steuerplatine (14) aufweist, wobei die Steuerplatine mit einer zweiten Steuereinheit versehen ist;
wobei die zweite Steuereinheit durch die Rückwandplatine mit dem Lüfter verbunden und konfiguriert ist, die maximale Lüfterdrehzahl dieser maximalen Lüfterdrehzahlen entsprechend den erfassten Informationen der maximalen Lüfterdrehzahlen jeder Hauptplatine (10) zu erhalten, um die Lüfterdrehzahl so zu steuern, dass eine Wärmeableitungsanforderung jeder Hauptplatine (10) erfüllt wird.

2. Server nach Anspruch 1, wobei
die Stromschnittstellen und die Lüfterschnittstellen an jeder Übergangsplatine (12) mit einer genormten Stromschnittstelle bzw. der genormten Lüfterschnittstelle auf jeder Hauptplatine (10) durch Kabel verbunden sind.

3. Server nach Anspruch 1, wobei
jede Hauptplatine (10) eine "Serveur System Infrastructure" (SSI)-Norm-Hauptplatine oder eine "Entry-level Electronics Bay" (EEB)-Norm-Hauptplatine oder eine "Compact Electronics Bay" (CEB)-Norm-Hauptplatine oder eine "Thin Electronics Bay" (TEB)-Norm-Hauptplatine ist.

4. Verfahren zum Steuern einer Lüfterdrehzahl in einem Server, wobei das Verfahren auf den Server nach einem der Ansprüche 1 bis 3 angewendet wird und das Verfahren die folgenden Schritte aufweist:
Erfassen (S31), Verfahren in jedem Knotenkasten, durch die erste Steuereinheit in der Übergangsplatine (12) von Lüfterdrehzahlinformationen, die für die Hauptplatine (10) benötigt werden; wobei die Lüfterdrehzahlinformationen, die für die Hauptplatine (10) benötigt werden, durch die Hauptplatine (10) entsprechend ihrer eigenen Temperatur erhalten werden; wobei eine erforderliche Lüfterdrehzahl umso höher ist, je höher die Temperatur ist;
Erfassen (S32), in jedem Knotenkasten, durch die erste Steuereinheit in der Übergangsplatine (12) einer maximalen Lüfterdrehzahl der Hauptplatine (10) entsprechend den Lüfterdrehzahlinformationen der Hauptplatine (10); und
Erhalten (S33) durch die zweite Steuereinheit in der Steuerplatine (14) des Servers der maximalen Lüfterdrehzahl dieser maximalen Lüfterdrehzahlen entsprechend der erfassten Informationen der maximalen Lüfterdrehzahlen jeder Hauptplatine (10), um die Lüfterdrehzahl so zu steuern, dass eine Wärmeableitungsanforderung jeder Hauptplatine (10) erfüllt wird.

## Revendications

1. Serveur comportant :
une alimentation électrique (16), un ventilateur (15), un fond (13) de panier, au moins deux boîtiers de noeuds, chaque boîtier de noeud comportant une carte mère (10) et une carte (12) de transition, le boîtier de noeud étant en liaison enfichable avec le fond (13) de panier par l'intermédiaire de la carte (12) de transition ;
chaque carte (12) de transition étant dotée d'interfaces d'alimentation et d'interfaces de ventilateurs, et les interfaces d'alimentation et les interfaces de ventilateurs sur chaque carte (12) de transition étant respectivement reliées à une interface d'alimentation normalisée et à une interface de ventilateur normalisée sur chaque carte mère (10) ; le nombre des interfaces d'alimentation sur chaque carte de transition et le nombre des interfaces de ventilateurs sur chaque carte de transition n'étant pas inférieurs respectivement au nombre maximal d'interfaces d'alimentation dans une carte mère de serveur d'utilisation courante et au nombre maximal d'interfaces de ventilateurs dans la carte mère de serveur d'utilisation courante ;
les interfaces d'alimentation et les interfaces de ventilateurs sur chaque carte (12) de transition étant reliées respectivement à l'alimentation électrique (16) et au ventilateur (15) par l'intermédiaire du fond (13) de panier, en sorte que les interfaces d'alimentation et les interfaces de ventilateurs sur chaque carte mère sont reliées à l'alimentation électrique et au ventilateur par l'intermédiaire des interfaces d'alimentation et des interfaces de ventilateurs sur chaque carte de transition respectivement,
une première unité de commande étant en outre disposée dans chaque carte de transition et configurée pour acquérir des informations de chaque carte mère ; et
le serveur comportant en outre une carte (14) de commande, la carte de commande étant dotée d'une deuxième unité de commande ; la deuxième unité de commande étant reliée au ventilateur par l'intermédiaire du fond de panier, et configurée pour réguler une vitesse de ventilateur selon le procédé de la revendication 4.

2. Serveur selon la revendication 1,
les interfaces d'alimentation et les interfaces de ventilateurs sur chaque carte (12) de transition étant reliées respectivement à une interface d'alimentation normalisée et à une interface de ventilateur normalisée sur chaque carte mère par l'intermédiaire de câbles.

3. Serveur selon la revendication 1,
chaque carte mère (10) étant une carte mère à la norme SSI d'infrastructure des systèmes serveurs, ou une carte mère à la norme EEB de cases électroniques d'entrée de gamme, ou une carte mère à la norme CEB de cases électroniques compactes, ou une carte mère à la norme TEB de cases électroniques minces.

4. Procédé de régulation d'une vitesse de ventilateur dans un serveur, le procédé étant appliqué au serveur selon l'une quelconque des revendications 1 à 3, et le procédé comportant les étapes suivantes, dans chaque boîtier de noeud :
acquisition (S31), par la première unité de commande de la carte de transition, d'informations de vitesse de ventilateur requises pour la carte mère ; les informations de vitesse de ventilateur requises pour la carte mère étant obtenues par la carte mère en fonction de sa propre température ; où plus la température est élevée, plus une vitesse de ventilateur requise est élevée ;
acquisition (S32), par la première unité de commande de la carte de transition, d'une vitesse maximale de ventilateur de la carte mère en fonction des informations de vitesse de ventilateur de chaque carte mère ; et
obtention (S33), par la deuxième carte de commande, de la vitesse maximale de ventilateur de ces vitesses maximales de ventilateurs en fonction d'informations acquises de vitesse maximale de ventilateur de chaque carte mère pour réguler la vitesse de ventilateur de façon à satisfaire une demande de dissipation thermique de chaque carte mère.
